# EUROPÄISCHE PATENTANMELDUNG

(11) **EP 4 815 307 A1**
(43) Veröffentlichungstag der Anmeldung: **30.09.2026**
(21) Anmeldenummer: 26164012.2
(22) Anmeldetag: 11.03.2026
(51) Int. Cl.: H03K 17/10, H03K 17/687

(54) **HALBLEITERBASIERTES SCHUTZSCHALTGERÄT UND BETRIEBSVERFAHREN**

(30) Priorität: 24.03.2025 DE 102025111227
(71) Anmelder: Siemens Aktiengesellschaft, 80333 München (DE)
(72) Erfinder: Handt, Karsten, 92224 Amberg (DE); Nannen, Hauke, 92224 Amberg (DE)
(74) Vertreter: Siemens Patent Attorneys

(57) **Zusammenfassung**

Die Erfindung betrifft ein halbleiterbasiertes Schutzschaltgerät (1), aufweisend
- netzseitige Anschlüsse (LG) und lastseitige Anschlüsse (LL),
- einen Hauptstrompfad (L) zum Leiten eines Hauptstroms zwischen den netzseitigen und den lastseitigen Anschlüssen (LG, LL),
- zwei antiseriell in den Hauptstrompfad (L) geschaltete selbstleitende Halbleiter-Stellglieder (JF), die jeweils einen Steueranschluss (G_JF) zur Spannungssteuerung der selbstleitenden Halbleiter-Stellglieder (JF) aufweisen,
- zwei antiseriell in den Hauptstrompfad (L) geschaltete selbstsperrende Halbleiter-Stellglieder (MF), die jeweils einen Steueranschluss (G_MF) zur Spannungssteuerung der selbstsperrenden Halbleiter-Stellglieder (MF) aufweisen,
- einen parallel zu den selbstsperrenden Halbleiter-Stellgliedern (MF) geschalteten Ladungsspeicher (C), der durch eine Sperrung des Hauptstroms durch die selbstsperrenden Halbleiter-Stellglieder (MF) geladen werden kann und im geladenen Zustand eine Versorgungsspannung (U_{elec}) zum Betreiben des Schutzschaltgeräts (1) bereitstellt.

## Beschreibung

### Technisches Gebiet

Die vorliegende Erfindung betrifft ein halbleiterbasiertes Schutzschaltgerät sowie ein Verfahren zum Betreiben eines solchen Schutzschaltgeräts.

### Technischer Hintergrund

Halbleiterbasierte Schutzschaltgeräte, in der folgenden Beschreibung auch mit dem englischen Begriff "Solid State Circuit Breaker" (= SSCB) bezeichnet, sind eine Alternative zu elektromechanischen Schutzschaltgeräten. SSCB weisen mindestens ein HL-Stellglied wie MOSFET, IGBT, etc. und eine Steuereinheit (engl.: Control Unit), die im Falle eines Fehlerereignisses, z. B. bei Überstrom oder Überlast in einem Hauptstromkreis, durch eine Ansteuerung des HL-Stellglieds einen Wechsel des HL-Stellglieds in einen hochohmigen Schaltzustand herbeiführt, auf (HL = Halbleiter). Häufig weist ein SSCB außerdem eine Strommessvorrichtung (kurz: Stromsensor) auf, mittels der ein Fehlerereignis im Hauptstromkreis detektiert werden kann. Zur Energieversorgung der Steuereinheit und des mindestens einen HL-Stellglieds ist eine Versorgungsspannung erforderlich, die entweder von außen dem SSCB zugeführt wird ("externe Spannungsversorgung") oder aus dem Hauptstromkreis entnommen wird ("interne Spannungsversorgung"). Im Fall der Entnahme der Versorgungsspannung aus dem Hauptstromkreis spricht man von einem eigenversorgten Gerät, da keine externe Spannungsversorgung erforderlich ist.

Üblich sind SSCBs, in denen selbstsperrende HL-Stellglieder zum Unterbrechen des Hauptstromkreises verwendet werden, d. h. HL-Stellglieder, die im spannungslosen Zustand, d. h. ohne Anliegen einer Ansteuerspannung, elektrisch sperrend, also in einem hochohmigen Schaltzustand, sind. Eine interne Spannungsversorgung eines solchen SSCB ist einfach dadurch zu realisieren, dass eine im selbstsperrenden Zustand des HL-Stellglieds über dem HL-Stellglied anliegende Spannung für die Spannungsversorgung des SSCB verwendet wird.

Selbstleitende HL-Stellglieder, d. h. HL-Stellglieder, die im spannungslosen Zustand, d. h. ohne Anliegen einer Ansteuerspannung, elektrisch leitend, also in einem niederohmigen Schaltzustand, sind, weisen gegenüber selbstsperrenden HL-Stellgliedern einige Vorteile auf. Daher besteht eine Nachfrage nach SSCs, in denen selbstleitende HL-Stellglieder zum Unterbrechen des Hauptstromkreises verwendet werden. Da sich aber über einem selbstleitenden HL-Stellglied von selbst keine Spannung aufbaut, ist eine Eigenversorgung eines SSC, in dem zum Unterbrechen des Hauptstromkreises selbstleitende HL-Stellglieder verwendet werden, problematisch.

### Zusammenfassung der Erfindung

Eine Aufgabe der vorliegenden Erfindung ist eine Eigenversorgung eines SSCB, welches zum Unterbrechen eines Hauptstromkreises selbstleitende HL-Stellglieder aufweist.

Diese Aufgabe wird durch ein Schutzschaltgerät gemäß Patentanspruch 1 gelöst. Diese Aufgabe wird außerdem durch ein Verfahren zum Betreiben eines Schutzschaltgeräts gemäß Patentanspruch 8 gelöst. Und die Aufgabe wird außerdem durch ein Computerprogrammprodukt gemäß Patentanspruch 14 gelöst.

Ein Aspekt der Erfindung ist ein halbleiterbasiertes Schutzschaltgerät; "halbleiterbasiert" heißt, dass das Schutzschaltgerät zur Erfüllung seiner Schutz- und Schaltaufgaben mindestens ein HL-Stellglied verwendet. Das Schutzschaltgerät weist netzseitige Anschlüsse und lastseitige Anschlüsse auf. Das Schutzschaltgerät weist einen Hauptstrompfad auf, der die netzseitigen und lastseitigen Anschlüsse elektrisch verbindet. Der Hauptstrompfad dient zum Leiten eines Hauptstroms von den netzseitigen zu den lastseitigen Anschlüssen. Der vorzugsweise durch ein Gehäuse des Schutzschaltgeräts geführte Hauptstrompfad bildet einen Abschnitt eines Hauptstromkreises, wenn das Schutzschaltgerät mit seinen netzseitigen Anschlüssen und lastseitigen Anschlüssen in einen Hauptstromkreis geschaltet ist.

Der Begriff "Hauptstrom" ist weit zu interpretieren: er umfasst jeden Strom durch den Hauptstrompfad, also zum Einen einen Laststrom zur elektrischen Versorgung einer elektrischen Last wie beispielsweise einer Antriebsvorrichtung (z. B. Elektromotor), einer Heizvorrichtung (z. B. Heizstrahler), einer Beleuchtungsvorrichtung (z. B. Leuchtdioden) oder eines Ladungsspeichers (z. B. Akkumulator, Kondensator) mit elektrischer Energie aus einem elektrischen Versorgungsnetz, zum Anderen aber auch einen Strom entlang des Hauptstrompfads, der von den lastseitigen Anschlüssen zu den netzseitigen Anschlüssen fließt, d. h. in einer Rückspeise-Situation, die in einer bidirektionalen DC-Stromversorgung auftreten kann, die sowohl eine Energie-Einspeisung aus dem Netz in eine Lastzone als auch eine Energie-Rückspeisung aus einem Netzabschnitt mit einer Energiequelle (z.B. einer Photovoltaikanlage oder einer geladenen Batterie) in das Netz erlaubt.

Das Schutzschaltgerät weist mindestens zwei antiseriell in den Hauptstrompfad geschaltete selbstleitende Halbleiter-Stellglieder auf. Die selbstleitenden Halbleiter-Stellglieder weisen jeweils einen Steueranschluss auf, über den die selbstleitenden Halbleiter-Stellglieder spannungsgesteuert werden können. Das Attribut "selbstleitend" sagt aus, dass die selbstleitenden Halbleiter-Stellglieder in einem niederohmigen, d. h. elektrisch leitenden, Zustand sind, falls an ihrem Steueranschluss keine Spannung anliegt.

Das Schutzschaltgerät weist außerdem mindestens zwei antiseriell in den Hauptstrompfad geschaltete selbstsperrende Halbleiter-Stellglieder auf. Die selbstsperrenden Halbleiter-Stellglieder weisen jeweils einen Steueranschluss auf, über den die selbstsperrenden Halbleiter-Stellglieder spannungsgesteuert werden können. Das Attribut "selbstsperrend" sagt aus, dass die selbstsperrenden Halbleiter-Stellglieder in einem hochohmigen, d. h. elektrisch nichtleitenden, Zustand sind, falls an ihrem Steueranschluss keine Spannung anliegt.

Das Schutzschaltgerät weist außerdem einen parallel zu den selbstsperrenden Halbleiter-Stellgliedern geschalteten Ladungsspeicher auf. Der Ladungsspeicher kann dadurch elektrisch geladen werden, dass der Hauptstrom durch den Hauptstrompfad mittels der selbstsperrenden Halbleiter-Stellglieder gesperrt wird. Der Ladungsspeicher stellt im geladenen Zustand eine Versorgungsspannung zum Betreiben des Schutzschaltgeräts bereit.

Das Schutzschaltgerät kann in ein- oder mehrphasigen Stromnnetzen eingesetzt werden: der Hauptstromkreis kann eine oder mehrere Phasen (= Phasenleiter) aufweisen. Das Schutzschaltgerät weist in mindestens einem Hauptstrompfad eine Schaltung aus selbstleitenden Halbleiter-Stellgliedern, selbstsperrenden Halbleiter-Stellgliedern und Ladungsspeicher auf; in der Regel weist es in jedem seiner ein oder mehreren Hauptstrompfaden eine solche Schaltung auf.

Die folgende Beschreibung bezieht sich auf einen einzigen Hauptstrompfad; es ist dem Fachmann jedoch klar, dass im Falle eines mehrphasigen Hauptstromkreises das Schutzschaltgerät je Phase einen Hauptstrompfad aufweisen kann, die alle gleich ausgebildet sind. An den netzseitigen Anschluss ist eine Spannungsquelle des Niederspannungsstromkreises, an den lastseitigen Anschluss ein elektrischer Verbraucher des Niederspannungsstromkreises angeschlossen. Der mindestens eine Strompfad bildet somit einen Abschnitt des Niederspannungsstromkreises. In dem mindestens einen Strompfad ist ein Halbleiter-Schalter angeordnet.

Ein halbleiterbasiertes Schutzschaltgerät kann als einer von verschiedenen Gerätetypen vorliegen, z. B. als ein Leistungsschalter (engl.: circuit breaker), ein Motorstarter, ein Relais, ein Schütz (engl.: contactor), etc. Das Leistungsteil eines SSCB umfasst je Phase üblicherweise mindestens ein HL-Stellglied, z. B. eine Verschaltung aus MOSFET, JFET, IGBT, o.ä., und, parallel zum HL- Stellglied, einen Energieabsorber (= EA), z. B. einen Varistor, eine TVS-Diode oder eine RC-Beschaltung. Der EA schützt, indem er eine am EA anliegende Spannung auf eine EA-spezifische Clampingspannung U_{C} begrenzt, den HL-Schalter vor einer Beschädigung, die durch eine bei einem Abschaltvorgang des HL-Schalters auftretende Überspannung hervorgerufen wird (spannungsbegrenzende Funktion), und baut die Energie (Abmagnetisierungsenergie), die in den Induktivitäten des Stromkreises, z. B. in Spulen oder in der Leitungsinduktivität, gespeichert ist, ab (energieabsorbierende Funktion). Eine gängige und relativ kostengünstige Variante ist der Überspannungsschutz mit einem Metalloxid-Varistor (= MOV).

Wäre das Schutzschaltgerät auf seinem Hauptstrompfad nur in einer einzigen definierten Richtung von dem Hauptstrom durchflossen (unidirektionales DC-Netz), so reichte eine Schaltung aus einem selbstleitenden Halbleiter-Stellglied, einem selbstsperrenden Halbleiter-Stellglied und einem Ladungsspeicher aus. Für eine Eignung des Schutzschaltgeräts in einem birektionalen DC-Netz oder in einem AC-Netz, in denen der Hauptstrom auf seinem Hauptstrompfad in beiden Richtungen erfolgen kann, müssen von den selbstleitenden Halbleiter-Stellgliedern und den selbstsperrenden Halbleiter-Stellglied jeweils zwei antiseriell verschaltete Pärchen vorhanden sein.

FETs sind spannungsgesteuerte Halbleiter-Stellglieder, weil die anliegende Steuerspannung = Gate-Source-Spannung V_{GS} den Halbleiter-Widerstand regelt, um so die Stärke eines elektrischen Stromes I_{DS} zwischen Source und Drain, der in dieser Erfindung dem Hauptstrom entspricht, zu schalten oder zu steuern. JFETs sind selbstleitende Halbleiter-Stellglieder, d. h. sie sind zwischen Source und Drain elektrisch leitend, wenn keine Steuerspannung anliegt. MOSFETs sind selbstsperrende Halbleiter-Stellglieder, d. h. sie sind zwischen Source und Drain elektrisch sperrend, wenn keine Steuerspannung anliegt. In Si und SiC gefertigte MOSFETs (Anreicherungstyp, Normal-AUS) werden oft für Schaltungsanwendungen im niedrigen und mittleren Leistungsbereich gewählt.

Der Erfindung liegt die Erkenntnis zugrunde, dass eine Eigenversorgung eines SSCB, welches zum Unterbrechen eines Hauptstroms selbstleitende HL-Stellglieder aufweist, durch selbstsperrende HL-Stellglieder möglich ist, die in Reihe zu den selbstleitenden HL-Stellgliedern geschaltet sind: ein parallel zu den selbstsperrenden HL-Stellgliedern verschalteter Ladungsspeicher kann durch den Hauptstrom geladen werden und stellt im geladenen Zustand eine Spannung zur Spannungsversorgung des SSCB bereit.

Da bisher in SSCB ausschließlich selbstsperrende HL-Stellglieder (Leistungshalbleiter) zum Unterbrechen eines Hauptstroms verwendet werden, stellt die Erfindung somit eine neuartige Lösung bereit, die ein verlässliches Unterbrechen eines Hauptstroms mit selbstleitenden HL-Stellglieder ermöglicht. Somit ermöglicht die Erfindung eine Eigenversorgung eines halbleiterbasierten Schutzschaltgeräts auch dann, wenn der Hauptteil der Sperrspannung von Halbleiter-Stellgliedern erbracht wird, die ohne Ansteuerspannung leitend sind.

Ein weiterer Aspekt der Erfindung ist ein Verfahren zum Betreiben eines halbleiterbasierten Schutzschaltgeräts, das zwei selbstleitende Halbleiter-Stellglieder aufweist, welche antiseriell in einen Hauptstrompfad des Schutzschaltgeräts geschaltet sind. Dabei weist das Verfahren einen Schritt auf, in dem ein Hauptstrom durch den Hauptstrompfad geleitet wird, der netzseitige und lastseitige Anschlüsse des Schutzschaltgeräts elektrisch verbindet, wobei der Hauptstrom durch eine zwischen den netzseitigen Anschlüssen und lastseitigen Anschlüssen anliegende Spannung hervorgerufen wird. Das Verfahren weist außerdem einen Schritt auf, in dem ein Ladungsspeicher, welcher parallel zu zwei antiseriell in den Hauptstrompfad geschalteten selbstsperrenden Halbleiter-Stellgliedern geschaltet ist, durch den hervorgerufenen Hauptstrom geladen wird, indem ein Hauptstrom durch die selbstsperrenden Halbleiter-Stellglieder gesperrt wird. Das Verfahren weist außerdem einen Schritt auf, in dem ein geladener Zustand des Ladungsspeichers erreicht wird, in welchem er eine Versorgungsspannung zum Betreiben des Schutzschaltgeräts bereitstellt. Und das Verfahren weist außerdem einen Schritt auf, in dem ein Betreiben des Schutzschaltgeräts mittels der vom Ladungsspeicher bereitgestellten Versorgungsspannung erfolgt.

Ein weiterer Aspekt der Erfindung ist ein Computerprogrammprodukt, das direkt in den internen Speicher einer digitalen Recheneinheit geladen werden kann und Softwarecodeabschnitte umfasst, die bewirken, dass das erfindungsgemäße Schutzschaltgerät die Verfahrensschritte des hierin beschriebenen Verfahrens ausführt, wenn das Produkt auf der Recheneinheit läuft. Die Recheneinheit ist insbesondere eine Recheneinheit zur Steuerung des Schutzschaltgeräts. Das Computerprogrammprodukt kann auf einem Datenträger gespeichert sein, wie z. B. einem USB-Speicherstick, einer DVD oder einer CD-ROM, einem Flash-Speicher, EEPROM oder einer SD-Karte (USB = Universal Serial Bus; DVD = Digital Versatile Disc; CD-ROM = Compact Disc-Read-Only Memory; EEPROM = electrically erasable programmable read-only memory; SD = Secure Digital). Das Computerprogrammprodukt kann auch in der Form eines über ein drahtgebundenes oder drahtloses Netzwerk ladbares Signal vorliegen.

Das Verfahren ist zur automatischen Ausführung bevorzugt in Form eines Computerprogramms realisiert. Die Erfindung ist damit einerseits auch ein Computerprogramm mit durch einen Computer ausführbaren Programmcodeanweisungen und andererseits ein Speichermedium mit einem derartigen Computerprogramm, also ein Computerprogrammprodukt mit Programmcodemitteln, sowie schließlich auch eine Energiequelle oder eine Tertiärregelungseinheit, in deren Speicher als Mittel zur Durchführung des Verfahrens und seiner Ausgestaltungen ein solches Computerprogramm geladen oder ladbar ist.

Wenn im Folgenden Verfahrensschritte oder Verfahrensschrittfolgen beschrieben werden, bezieht sich dies auf Aktionen, die aufgrund des Computerprogramms oder unter Kontrolle des Computerprogramms erfolgen, sofern nicht ausdrücklich darauf hingewiesen ist, dass einzelne Aktionen durch einen Benutzer des Computerprogramms veranlasst werden. Zumindest bedeutet jede Verwendung des Begriffs "automatisch", dass die betreffende Aktion aufgrund des Computerprogramms oder unter Kontrolle des Computerprogramms erfolgt.

Anstelle eines Computerprogramms mit einzelnen Programmcodeanweisungen kann die Implementierung des hier und im Folgenden beschriebenen Verfahrens auch in Form von Firmware erfolgen. Dem Fachmann ist klar, dass anstelle einer Implementation eines Verfahrens in Software stets auch eine Implementation in Firmware oder in Firm- und Software oder in Firm- und Hardware möglich ist. Daher soll für die hier vorgelegte Beschreibung gelten, dass von dem Begriff Software oder dem Begriff Computerprogramm auch andere Implementationsmöglichkeiten, nämlich insbesondere eine Implementation in Firmware oder in Firm- und Software oder in Firm- und Hardware, umfasst sind.

Ein weiterer Aspekt der Erfindung ist ein Computerlesbares Medium, auf dem das Computerprogramm nach Anspruch 14 gespeichert ist.

### Ausgestaltungen der Erfindung

Vorteilhafte Ausgestaltungen und Weiterbildungen der Erfindung sind in den abhängigen Ansprüchen angegeben. Dabei kann das erfindungsgemäße Verfahren auch entsprechend den abhängigen Vorrichtungsansprüchen weitergebildet sein, und umgekehrt.

Gemäß einer bevorzugten Ausgestaltung der Erfindung weist das Schutzschaltgerät eine Steuereinheit zur Spannungssteuerung der Halbleiter-Stellglieder auf, wobei der Ladungsspeicher im geladenen Zustand eine Versorgungsspannung für die Steuereinheit und die Spannungssteuerung der Halbleiter-Stellglieder bereitstellt.

Gemäß einer bevorzugten Ausgestaltung der Erfindung sind die selbstsperrenden Halbleiter-Stellglieder zwischen den selbstleitenden Halbleiter-Stellgliedern verschaltet. In dieser Verschaltung werden die beiden selbstleitenden Halbleiter-Stellglieder um die selbstsperrenden Halbleiter-Stellglieder angeordnet. Dadurch hat die im Ladungsspeicher erzeugte Versorgungsspannung bereits den richtigen Potentialbezug für die Ansteuerung der selbstleitenden Halbleiter-Stellglieder: Der Bezugspunkt (Ground) liegt zwischen den beiden selbstleitenden Halbleiter-Stellgliedern, so dass deren Steueranschlüsse (Gate) angesteuert werden können

Gemäß einer bevorzugten Ausgestaltung der Erfindung sind die selbstsperrenden Halbleiter-Stellglieder und die selbstleitenden Halbleiter-Stellgliedern jeweils paarweise antiseriell in Reihe verschaltet. Paarweise antiseriell bedeutet, dass die Bauteile unmittelbar spiegelverkehrt miteinander verbunden sind (Drain mit Drain oder Source mit Source). Bei dieser Verschaltung, die eine Alternative zu der vorgenannten Verschaltung bildet, besteht allerdings das Problem, dass die im Ladungsspeicher erzeugte Versorgungsspannung einen festen Potentialbezug durch die Schaltung hat. Der Bezugspunkt (Ground) liegt zwischen den beiden selbstsperrenden Halbleiter-Stellgliedern, er sollte aber zwischen den beiden selbstleitenden Halbleiter-Stellglieder liegen, um deren Steueranschlüsse (Gate) ansteuern zu können. Will man nun die im Ladungsspeicher erzeugte Versorgungsspannung für die Ansteuerung nutzen, wird eine weitere Potentialtrennung benötigt, was Kosten und Aufwand bedeutet. Außerdem senkt diese Potentialtrennung die Geschwindigkeit, in der die Versorgungsspannung auf dem richtigem Potential vorhanden ist, z. B. durch eine Verzögerung vei Verwendung eines isolierten DC-DC-Wandlers.

Gemäß einer bevorzugten Ausgestaltung der Erfindung weist das Schutzschaltgerät eine Strommessvorrichtung im Hauptstrompfad auf. Die Strommessvorrichtung kann entweder als eine separate Einrichtung, z. B. einen Strommesswiderstand (= Shunt), einen Hallsensor, etc., vorliegen oder die Stromstärke im Hauptstrompfad kann über einen Spannungsabfall an den Halbleiter-Stellgliedern bestimmt werden.

Gemäß einer bevorzugten Ausgestaltung der Erfindung weist das Schutzschaltgerät mindestens ein Schaltelement auf, durch welches der Ladungsspeicher mit den Steueranschlüssen der selbstleitenden Halbleiter-Stellglieder elektrisch verbunden oder davon getrennt werden kann. Das besagte Schaltelement kann als ein elektromechanischer Schalter, z. B. ein Relais, ausgebildet sein. Das besagte Schaltelement kann alternativ als ein elektronischer Kontakt ausgeführt, z. B. Transistor, Optokoppler oder Kombinationen. Mittels des Schaltelements kann die Betriebsart des Schutzschaltgeräts umgeschaltet werden. Ist das Schaltelement in einem leitenden bzw. niederohmigen Schaltzustand, werden die selbstleitenden Halbleiter-Stellglieder und die selbstsperrenden Halbleiter-Stellglieder auf eine Art verschaltet, die in der Literatur als Kaskodenschaltung bekannt ist: sperren die selbstsperrenden Halbleiter-Stellglieder, gehen auch die selbstleitenden Halbleiter-Stellglieder in einen sperrenden Zustand. Ist das Schaltelement in einem sperrenden bzw. hochohmigen Schaltzustand, befinden sich die selbstleitenden Halbleiter-Stellglieder in einem dauerhaft leitenden Zustand und die selbstsperrenden Halbleiter-Stellglieder können unabhängig von den selbstleitenden Halbleiter-Stellgliedern gesteuert werden.

Gemäß einer bevorzugten Ausgestaltung der Erfindung ist das vorgenannte mindestens eine Schaltelement, durch welches der Ladungsspeicher mit den Steueranschlüssen der selbstleitenden Halbleiter-Stellglieder elektrisch verbunden oder davon getrennt werden kann, durch die Steuereinheit betätigbar. Das Schaltelement ist vorzugsweise als ein elektronischer Kontakt ausgeführt, z. B. Transistor, Optokoppler oder Kombinationen.

Gemäß einer bevorzugten Ausgestaltung der Erfindung sind die selbstleitenden Halbleiter-Stellglieder HV-Transistoren (HV = High Voltage = Hochspannung). Ein HV-Transistor ist ein Transistor mit einer relativ hohen Durchbruchspannung. Ein Beispiel für einen HV-Transistor ist ein JFET (= junction field-effect transistor = Sperrschicht-Feldeffekttransistor).

Gemäß einer bevorzugten Ausgestaltung der Erfindung sind die selbstsperrenden Halbleiter-Stellglieder LV-Transistoren (LV = Low Voltage = Niederspannung). Ein LV-Transistor ist ein Transistor mit einer relativ niedrigen Durchbruchspannung. Ein Beispiel für einen LV-Transistor ist ein MOSFET (= metal oxide semiconductor field-effect transistor = Metall-Oxid-Halbleiter-Feldeffekttransistor).

Gemäß einer bevorzugten Ausgestaltung der Erfindung sind die selbstsperrenden Halbleiter-Stellglieder Niederspannungsbauelemente. Unter Niederspannungsbauelementen werden Bauelemente mit einer maximalen Blockierspannung von weniger als 85 Volt verstanden.

Gemäß einer bevorzugten Ausgestaltung der Erfindung sind die selbstleitenden Halbleiter-Stellglieder Hochspannungsbauelemente. Unter Hochspannungsbauelementen werden Bauelemente mit einer maximalen Blockierspannung größer oder gleich 200 Volt, vorzugsweise größer oder gleich 1000 Volt, verstanden.

Gemäß einer bevorzugten Ausgestaltung der Erfindung wird zur Reduktion von Verlusten in dem leitenden Zustand der selbstleitenden Halbleiter-Stellglieder ein zur Spannungsansteuerung der selbstleitenden Halbleiter-Stellglieder angesteuerter Steueranschluss mit einer positiven Gate-Source-Spannung (z. B. +2 V) angesteuert, da JFETs unter diesen Bedingungen oftmals die geringsten Durchlassverluste aufweisen.

Gemäß einer bevorzugten Ausgestaltung der Erfindung weist das Verfahren folgenden Schritt auf: Betreiben einer Steuereinheit, die zur Spannungssteuerung der Halbleiter-Stellglieder ausgebildet ist, und/oder der zwei selbstleitenden Halbleiter-Stellglieder und/oder der zwei selbstsperrenden Halbleiter-Stellglieder mittels der vom Ladungsspeicher bereitgestellten Versorgungsspannung.

Gemäß einer bevorzugten Ausgestaltung der Erfindung weist das Verfahren folgenden Schritt auf: Falls die Versorgungsspannung unter einen definierten kritischen Schwellwert sinkt, werden die selbstsperrenden Halbleiter-Stellglieder von einem leitenden Zustand in einen sperrenden Zustand gebracht, um den Ladungsspeicher wieder über den Schwellwert aufzuladen.

Gemäß einer bevorzugten Ausgestaltung der Erfindung wird die Länge eines Zeitraums, während dessen die selbstsperrenden Halbleiter-Stellglieder zum Aufladen des Ladungsspeichers in einem sperrenden Zustand sind, in Abhängigkeit vom Hauptstrom und von den an den Ladungsspeicher angeschlossenen Lasten gewählt.

Gemäß einer bevorzugten Ausgestaltung der Erfindung sind die selbstleitenden Halbleiter-Stellglieder mit den selbstsperrenden Halbleiter-Stellgliedern in einer Kaskodenschaltung so verschaltet sind, dass die selbstleitenden Halbleiter-Stellglieder in den sperrenden Zustand wechseln, sobald der Ladungsspeicher eine Versorgungsspannung aufgebaut hat, die zur Ansteuerung der selbstleitenden Halbleiter-Stellglieder ausreicht.

Gemäß einer bevorzugten Ausgestaltung der Erfindung wird bei einer Detektion eines Kurzschlussstroms im Hauptstrompfad der auf eine zur Ansteuerung der selbstleitenden Halbleiter-Stellglieder ausreichende Versorgungsspannung geladene Ladungsspeicher mittels eines Schaltelements mit Steueranschlüssen der selbstleitenden Halbleiter-Stellglieder elektrisch so verbunden, dass die selbstleitenden Halbleiter-Stellglieder in den sperrenden Zustand wechseln.

### Exemplarische Ausführungsbeispiele der Zeichnung

Die oben beschriebenen Eigenschaften, Merkmale und Vorteile dieser Erfindung sowie die Art und Weise, wie diese erreicht werden, werden klarer und deutlicher verständlich durch die folgende Beschreibung der Ausführungsbeispiele, welche anhand der Zeichnungen näher erläutert werden. Es zeigt jeweils schematisch und nicht maßstabsgetreu
Fig. 1 ein Schaltbild eines Schutzschaltgeräts, bei dem die selbstsperrenden Halbleiter-Stellglieder und die selbstleitenden Halbleiter-Stellglieder jeweils paarweise antiseriell in Reihe miteinander verschaltet sind;
Fig. 2 ein Schaltbild eines Schutzschaltgeräts, bei dem die selbstsperrenden Halbleiter-Stellglieder antiseriell zwischen den selbstleitenden Halbleiter-Stellgliedern verschaltet sind;
Fig. 3 eine vereinfachte Darstellung von Fig. 2 zur Erläuterung der verschiedenen Betriebsarten, die in Fig. 4 bis 9 beschrieben sind;
Fig. 4 eine Übersicht verschiedener Betriebsarten;
Fig. 5-6 Vorgänge bei Ausbildung des Netzes und nennenswerter Last (= Standardfall);

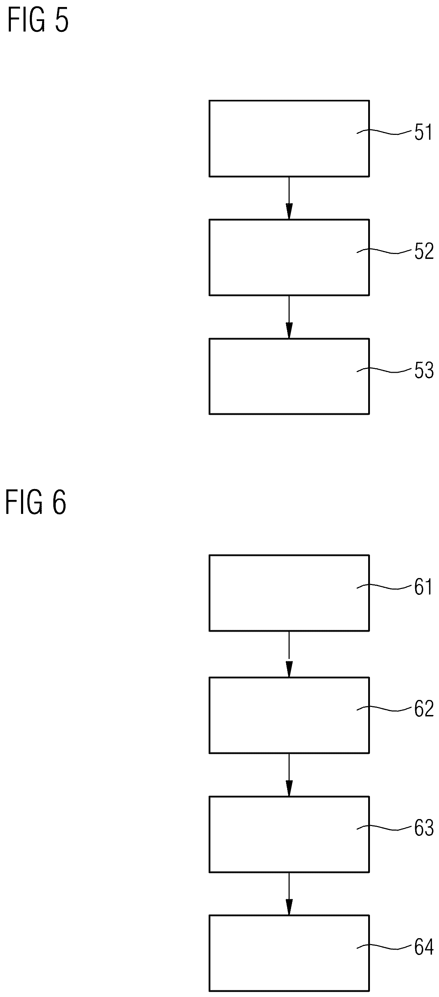

Fig. 5 einen Vorgang bei Ausbildung des Netzes und nennenswerter Last: Betrieb, der unmittelbar in einen leitenden Zustand übergeht: S1 ist sperrend;
Fig. 6 einen Vorgang bei Ausbildung des Netzes und nennenswerter Last: Betrieb, der erst nach Freigabe in einen leitenden Zustand übergeht: S1 ist leitend;

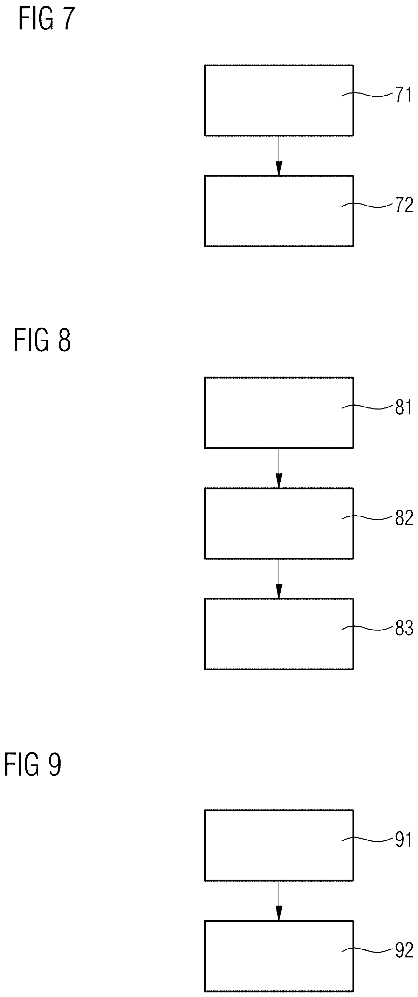

Fig. 7 einen Vorgang bei Ausbildung des Netzes und keiner Last (Extremfall 1: kein Hauptstrom): sowohl Betrieb A als auch B;
Fig. 8-9 Vorgänge bei Ausbildung des Netzes und Kurzschluss (Extremfall 2: zu hoher Hauptstrom = Kurzschluss);
Fig. 8 einen Vorgang bei Ausbildung des Netzes und Kurzschluss : Betrieb, der unmittelbar in einen leitenden Zustand übergeht: S1 ist sperrend; und
Fig. 9 einen Vorgang bei Ausbildung des Netzes und Kurzschluss : Betrieb, der erst nach Freigabe in einen leitenden Zustand übergeht: S1 ist leitend.

### Detaillierte Beschreibung der Ausführungsbeispiele

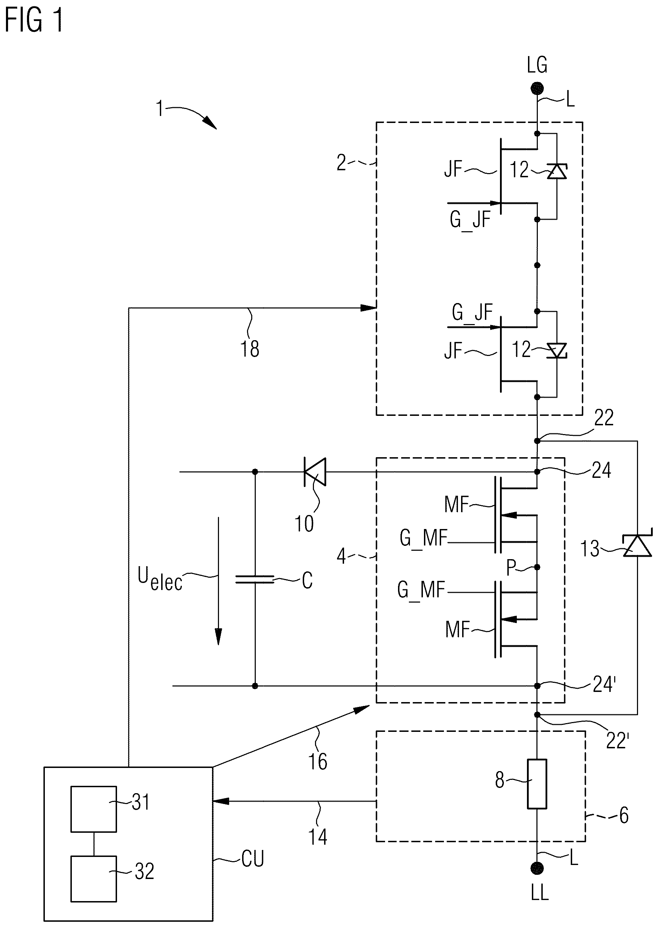

Fig. 1 ist ein Schaltbild eines Schutzschaltgeräts 1. Das Schutzschaltgerät 1 weist netzseitige Anschlüsse LG und lastseitige Anschlüsse LL auf. Diese Anschlüsse LG, LL können zum Beispiel als Schraub- oder Steckanschlüsse ausgebildet sein, mit denen Phasenleiter mit dem Schutzschaltgerät 1 elektrisch verbindbar sind. Das Schutzschaltgerät 1 weist einen Hauptstrompfad L zum Leiten eines Hauptstroms zwischen den netzseitigen und den lastseitigen Anschlüssen LG, LL auf.

Das Schutzschaltgerät 1 weist zwei antiseriell in den Hauptstrompfad L geschaltete selbstleitende Halbleiter-Stellglieder JF auf, die jeweils einen Steueranschluss G_JF zur Steuerung der selbstleitenden Halbleiter-Stellglieder JF aufweisen. Die selbstleitenden Halbleiter-Stellglieder JF sind als JFETs ausgebildet. Die zwei selbstleitenden Halbleiter-Stellglieder JF bilden einen HV-Schalter 2.

Das Schutzschaltgerät 1 weist zwei antiseriell in den Hauptstrompfad L geschaltete selbstsperrende Halbleiter-Stellglieder MF auf, die jeweils einen Steueranschluss G_MF zur Steuerung der selbstsperrenden Halbleiter-Stellglieder MF aufweisen. Die selbstsperrenden Halbleiter-Stellglieder MF sind als MOSFETs ausgebildet. Die zwei selbstsperrenden Halbleiter-Stellglieder MF bilden einen LV-Schalter 4.

Der leistungselektronische Teil des Schutzschaltgerät 1 ist also aufgetrennt in einen HV- und einen LV-Teil. Der HV-Teil umfasst die JFETs JF und der LV-Teil die MOSFETs MF. Die selbstsperrenden Halbleiter-Stellglieder MF und die selbstleitenden Halbleiter-Stellglieder JF sind jeweils paarweise antiseriell miteinander verschaltet, d. h. der HV-Schalter 2 ist im Hauptstrompfad L zwischen dem netzseitigen Anschluss LG und dem LV-Schalter 4 angeordnet.

Das Schutzschaltgerät 1 weist einen parallel zu den selbstsperrenden Halbleiter-Stellgliedern MF geschalteten Ladungsspeicher C in Form eines Kondensators auf, der durch eine Sperrung des Hauptstroms durch die selbstsperrenden Halbleiter-Stellglieder MF geladen werden kann und im geladenen Zustand eine Versorgungsspannung U_{elec} zum Betreiben des Schutzschaltgeräts 1 bereitstellt. Der Ladungsspeicher C ist parallel zu dem HV-Schalter 2 mit den selbstleitenden Halbleiter-Stellgliedern JF geschaltet; dabei ist der Ladungsspeicher C an zwei Kontaktpunkten 24, 24' zu beiden Seiten des LV-Schalters 4 an den Hauptstrompfad L angeschlossen. Um eine Entladung des Ladungsspeicher C zu verhindern, ist eine Diode 10 in der elektrischen Leitung angeordnet, die einen Pol des Ladungsspeichers C mit dem Hauptstrompfad L verbindet.

Das Schutzschaltgerät 1 weist eine Steuereinheit CU zur Spannungssteuerung der Halbleiter-Stellglieder JF, MF auf. Dabei stellt der Ladungsspeicher C im geladenen Zustand eine Versorgungsspannung Uelec für die Steuereinheit CU und die Spannungssteuerung der Halbleiter-Stellglieder JF, MF bereit. Die Steuereinheit CU weist eine digitalen Recheneinheit 31, z. B. einen Mikroprozessor, sowie einen Datenspeicher 32, auf dem ein Computerprogrammprodukt gespeichert ist, auf. Das Computerprogrammprodukt kann direkt in den internen Speicher der digitalen Recheneinheit 31 geladen werden; es umfasst Softwarecodeabschnitte, die bewirken, dass das erfindungsgemäße Schutzschaltgerät 1 die Verfahrensschritte des hierin beschriebenen Verfahrens ausführt, wenn das Computerprogrammprodukt auf der digitalen Recheneinheit 31 läuft.

Das Schutzschaltgerät 1 weist eine Strommessvorrichtung 6 im Hauptstrompfad L auf. Die Strommessvorrichtung 6 ist im Hauptstrompfad L zwischen dem lastseitigen Anschluss LL und dem LV-Schalter 4 angeordnet. Die Strommessvorrichtung 6 weist einen Strommesswiderstand 8 auf. Von der Strommessvorrichtung 6 ermittelte Stromwerte werden durch einen Datenübertragungspfad 14 an die Steuereinheit CU übertragen. In der Steuereinheit CU werden in Abhängigkeit von den erhaltenen Stromwerten Ansteuerbefehle zur Spannungssteuerung der Halbleiter-Stellglieder JF, MF generiert und durch die Ansteuerpfade 16, 18 an die Halbleiter-Stellglieder JF, MF übertragen. Die Spannung zum Betrieb der Steuereinheit CU und zur Spannungssteuerung des HV-Schalters 2 und des LV-Schalters 4 wird durch die im Ladungsspeicher C gespeicherte Versorgungsspannung Uelec bereitgestellt.

Parallel zu dem LV-Schalter 4 mit den selbstsperrenden Halbleiter-Stellgliedern MF ist eine Avalanche-Diode 13 (bidirektionaler Durchbrucheffekt) geschaltet, die an den beiden Kontaktpunkten 22, 22' zu beiden Seiten des LV-Schalters 4 an den Hauptstrompfad L angeschlossen ist. Parallel zu den selbstleitenden Halbleiter-Stellgliedern JF ist jeweils eine unidirektionale Durchbruch-Diode 12 geschaltet.

Bei der in Fig. 1 gezeigten Verschaltung, bei der die selbstsperrenden Halbleiter-Stellglieder MF und die selbstleitenden Halbleiter-Stellglieder JF jeweils paarweise antiseriell miteinander verschaltet sind, besteht allerdings das Problem, dass die im Ladungsspeicher C erzeugte Versorgungsspannung Uelec einen festen Potentialbezug durch die Schaltung hat. Der Potential-Bezugspunkt P (Ground) liegt zwischen den beiden selbstsperrenden Halbleiter-Stellgliedern MF, er sollte aber zwischen den beiden selbstleitenden Halbleiter-Stellgliedern JF liegen, um deren Steueranschlüsse G_JF (Gate) ansteuern zu können. Will man nun die die im Ladungsspeicher C erzeugte Versorgungsspannung Uelec für die Ansteuerung nutzen, wird eine weitere Potentialtrennung benötigt, was Kosten und Aufwand bedeutet. Außerdem senkt diese Potentialtrennung die Geschwindigkeit, in der die Versorgungsspannung Uelec auf dem richtigem Potential vorhanden ist, z. B. durch eine Verzögerung durch einen isolierten DC-DC-Wandler.

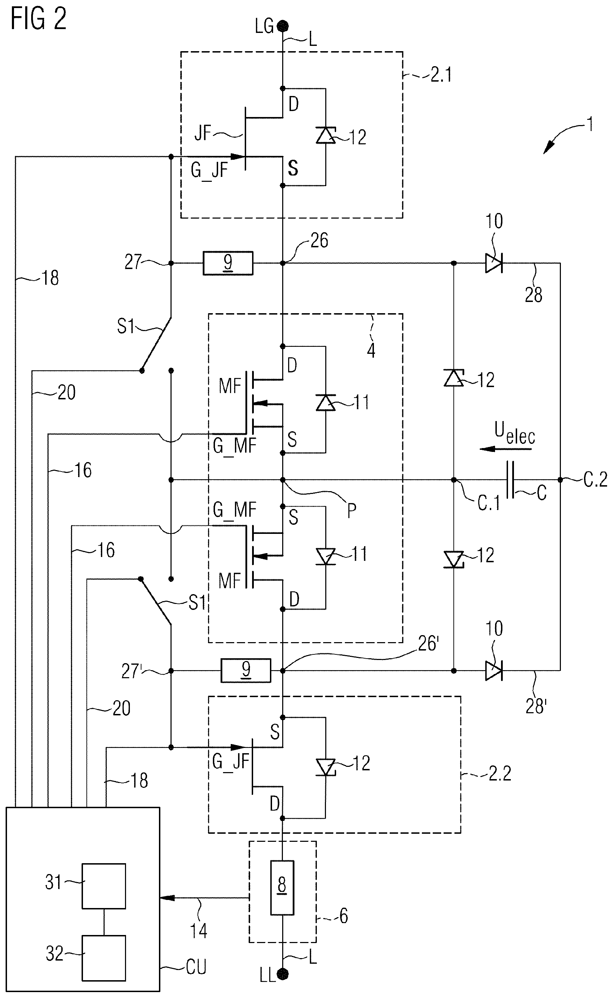

Figur 2 zeigt ein alternatives Schaltbild eines Schutzschaltgeräts 1. Das Schutzschaltgerät 1 weist, ebenso wie in Fig. 1, netzseitige Anschlüsse LG und lastseitige Anschlüsse **LL** auf. Diese Anschlüsse LG, LL können zum Beispiel als Schraub- oder Steckanschlüsse ausgebildet sein, mit denen Phasenleiter mit dem Schutzschaltgerät 1 elektrisch verbindbar sind. Das Schutzschaltgerät 1 weist, ebenso wie in Fig. 1, einen Hauptstrompfad L zum Leiten eines Hauptstroms zwischen den netzseitigen und den lastseitigen Anschlüssen LG, LL auf. Das Schutzschaltgerät 1 weist zwei antiseriell in den Hauptstrompfad L geschaltete selbstleitende Halbleiter-Stellglieder JF auf, die jeweils außer einem Source-Anschluss S und einem Drain-Anschluss D auch einen Steueranschluss G_JF zur Spannungssteuerung der selbstleitenden Halbleiter-Stellglieder JF aufweisen. Die selbstleitenden Halbleiter-Stellglieder JF sind als JFETs ausgebildet. Die zwei selbstleitenden Halbleiter-Stellglieder JF bilden einen HV-Schalter 2.

Das Schutzschaltgerät 1 weist zwei antiseriell in den Hauptstrompfad L geschaltete selbstsperrende Halbleiter-Stellglieder MF auf, die jeweils außer einem Source-Anschluss S und einem Drain-Anschluss D auch einen Steueranschluss G_MF zur Spannungssteuerung des selbstsperrenden Halbleiter-Stellglieds MF aufweisen. Die selbstsperrenden Halbleiter-Stellglieder MF sind als MOSFETs ausgebildet. Die zwei selbstsperrenden Halbleiter-Stellglieder MF sind unmittelbar nebeneinander verschaltet und bilden einen LV-Schalter 4.

Der leistungselektronische Teil des Schutzschaltgerät 1s ist also aufgetrennt in einen HV- und einen LV-Teil. Der HV-Teil umfasst die beiden JFETs JF, und der LV-Teil die beiden MOSFETs MF. Im Gegensatz zu der in Fig. 1 gezeigten Schaltung sind nur die selbstsperrenden Halbleiter-Stellglieder MF, die den LV-Schalter 4 bilden, paarweise antiseriell miteinander verschaltet; dagegen sind die beiden selbstleitenden Halbleiter-Stellglieder JF auf beiden Seiten des LV-Schalters 4 angeordnet, d. h. der LV-Schalter 4 ist im Hauptstrompfad L von den beiden selbstleitenden Halbleiter-Stellgliedern JF umgeben. Der HV-Schalter 2 weist somit einen ersten HV-Teil-Schalter 2.1, d. h. ein zwischen dem netzseitigen Anschluss LG und dem LV-Schalter 4 im Hauptstrompfad L angeordnetes erstes selbstleitendes Halbleiter-Stellglied JF, und einen zweiten HV-Teil-Schalter 2.2, d. h. ein zwischen dem lastseitigen Anschluss LL und dem LV-Schalter 4 im Hauptstrompfad L angeordnetes zweites selbstleitendes Halbleiter-Stellglied JF, auf.

Das Schutzschaltgerät 1 weist einen mit den selbstsperrenden Halbleiter-Stellgliedern MF verschalteten Ladungsspeicher C in Form eines Kondensators auf, der durch eine Sperrung des Hauptstroms durch die selbstsperrenden Halbleiter-Stellglieder MF geladen werden kann und im geladenen Zustand eine Versorgungsspannung U_{elec} zum Betreiben des Schutzschaltgeräts 1 bereitstellt. Ein erster Anschluss C.1 des Ladungsspeichers C ist mit einem Potential-Bezugspunkt P (Ground), der zwischen den beiden selbstsperrenden Halbleiter-Stellgliedern MF liegt, elektrisch verbunden. Ein zweiter Anschluss C.2 des Ladungsspeichers C ist mit zwei Kontaktpunkten 26, 26' elektrisch verbunden, die jeweils zwischen dem LV-Schalter 4 und einem der beiden selbstleitenden Halbleiter-Stellglieder JF liegen. Um eine Entladung des Ladungsspeicher C zu verhindern, ist jeweils eine Diode 10 in den elektrischen Leitungen 28, 28' angeordnet, die den zweiten Anschluss C.2 des Ladungsspeichers C mit dem Hauptstrompfad L verbinden.

Das Schutzschaltgerät 1 weist eine Steuereinheit CU zur Spannungssteuerung der Halbleiter-Stellglieder JF, MF auf. Dabei stellt der Ladungsspeicher C im geladenen Zustand eine Versorgungsspannung Uelec für die Steuereinheit CU und die Spannungssteuerung der Halbleiter-Stellglieder JF, MF bereit. Die Steuereinheit CU weist eine digitalen Recheneinheit 31, z. B. einen Mikroprozessor, sowie einen Datenspeicher 32, auf dem ein Computerprogrammprodukt gespeichert ist, auf. Das Computerprogrammprodukt kann direkt in den internen Speicher der digitalen Recheneinheit 31 geladen werden; es umfasst Softwarecodeabschnitte, die bewirken, dass das erfindungsgemäße Schutzschaltgerät 1 die Verfahrensschritte des hierin beschriebenen Verfahrens ausführt, wenn das Computerprogrammprodukt auf der digitalen Recheneinheit 31 läuft.

Das Schutzschaltgerät 1 weist eine Strommessvorrichtung 6 im Hauptstrompfad L auf. Die Strommessvorrichtung 6 ist im Hauptstrompfad L zwischen dem lastseitigen Anschluss LL und dem zweiten HV-Teil-Schalter 2.2 angeordnet. Die Strommessvorrichtung 6 weist einen Strommesswiderstand 8 auf. Von der Strommessvorrichtung 6 ermittelte Stromwerte werden durch einen Datenübertragungspfad 14 an die Steuereinheit CU übertragen. In der Steuereinheit CU werden in Abhängigkeit von den erhaltenen Stromwerten Ansteuerbefehle zur Spannungssteuerung der Halbleiter-Stellglieder JF, MF generiert und durch die Ansteuerpfade 16, 18 an die Halbleiter-Stellglieder JF, MF übertragen. Die Spannung zum Betrieb der Steuereinheit CU und zur Spannungssteuerung des HV-Schalters 2 und des LV-Schalters 4 wird durch die im Ladungsspeicher C gespeicherte Versorgungsspannung Uelec bereitgestellt.

Parallel zu dem LV-Schalter 4 mit den selbstsperrenden Halbleiter-Stellgliedern MF parallel und den selbstleitenden Halbleiter-Stellgliedern JF sind jeweils unidirektionale Durchbruch-Dioden 12 geschaltet. Zusätzlich weist jeder der selbstsperrenden Halbleiter-Stellglieder MF eine BodyDiode 11 auf.

Das Schutzschaltgerät 1 weist außerdem eine Strommessvorrichtung 6 im Hauptstrompfad L auf. Die Strommessvorrichtung 6 ist im Hauptstrompfad L zwischen dem lastseitigen Anschluss LL und dem zweiten HV-Teil-Schalter 2.2 angeordnet. Die Strommessvorrichtung 6 weist einen Strommesswiderstand 8 auf. Von der Strommessvorrichtung 6 ermittelte Stromwerte werden durch einen Datenübertragungspfad 14 an die Steuereinheit CU übertragen. In der Steuereinheit CU werden in Abhängigkeit von den erhaltenen Stromwerten Ansteuerbefehle zur Spannungssteuerung der Halbleiter-Stellglieder JF, MF generiert und durch die Ansteuerpfade 16, 18 an die Halbleiter-Stellglieder JF, MF übertragen. Diese Ansteuerbefehle werden als Ansteuerspannungen realisiert, die an die Steueranschlüsse G_JF und G_MF der Halbleiter-Stellglieder JF, MF angelegt werden. Die Spannung zum Betrieb der Steuereinheit CU und zur Spannungssteuerung des HV-Schalters 2, 2.1, 2.2 und des LV-Schalters 4 wird durch die im Ladungsspeicher C gespeicherte Versorgungsspannung Uelec bereitgestellt.

Das Schutzschaltgerät 1 weist außerdem zwei Schaltelemente S1 auf, durch die der Ladungsspeicher C mit den Steueranschlüssen G_JF der selbstleitenden Halbleiter-Stellglieder JF elektrisch verbunden oder davon getrennt werden kann. Dabei sind die Schaltelemente S1 über Ansteuerpfade 20 durch die Steuereinheit CU betätigbar. Da die Schaltelemente S1 als elektronische Kontakte ausgebildet sind, nämlich als Transistoren, kann die Steuereinheit CU mittels eines Steuersignals über die Ansteuerpfade 20 die Schaltelemente S1 ansteuern. Sind die Schaltelemente S1 in einem leitenden bzw. niederohmigen Schaltzustand, werden die selbstleitenden Halbleiter-Stellglieder JF und die selbstsperrenden Halbleiter-Stellglieder MF auf eine Art verschaltet, die in der Literatur als Kaskodenschaltung bekannt ist: sperren die selbstsperrenden Halbleiter-Stellglieder MF, gehen auch die selbstleitenden Halbleiter-Stellglieder JF in einen sperrenden Zustand. Sind die Schaltelemente S1 in einem sperrenden bzw. hochohmigen Schaltzustand, befinden sich die selbstleitenden Halbleiter-Stellglieder JF in einem dauerhaft leitenden Zustand und die selbstsperrenden Halbleiter-Stellglieder MF können unabhängig von den selbstleitenden Halbleiter-Stellgliedern JF gesteuert werden.

Das Schutzschaltgerät 1 weist außerdem zwei elektrische Widerstände 9 auf. Ein erster elektrischer Anschluss dieser Widerstände 9 ist mit dem Hauptstrompfad L verbunden, und zwar an einem Kontaktpunkt 26, 26', der zwischen den ersten bzw. zweiten HV-Teil-Schaltern 2.1, 2.2 und dem LV-Schalter 4 liegt. Ein zweiter elektrischer Anschluss dieser Widerstände 9 ist mit einem Kontaktpunkt 27, 27' verbunden, der zwischen den Steueranschlüssen G_JF der selbstleitenden Halbleiter-Stellglieder JF und dem Potential-Bezugspunkt P liegt.

Der Vorteil der in Fig. 2 gezeigten Verschaltung, bei der die selbstsperrenden Halbleiter-Stellglieder MF von den selbstleitenden Halbleiter-Stellgliedern JF umgeben sind, ist, dass die im Ladungsspeicher C erzeugte Versorgungsspannung Uelec einen festen Potentialbezug durch die Schaltung hat, bei der der Potential-Bezugspunkt P (Ground) zwischen den beiden selbstleitenden Halbleiter-Stellgliedern JF liegt; somit sind die Potentiale passend für eine Ansteuerung der Steueranschlüsse G_JF (Gate) der selbstleitenden Halbleiter-Stellglieder JF.

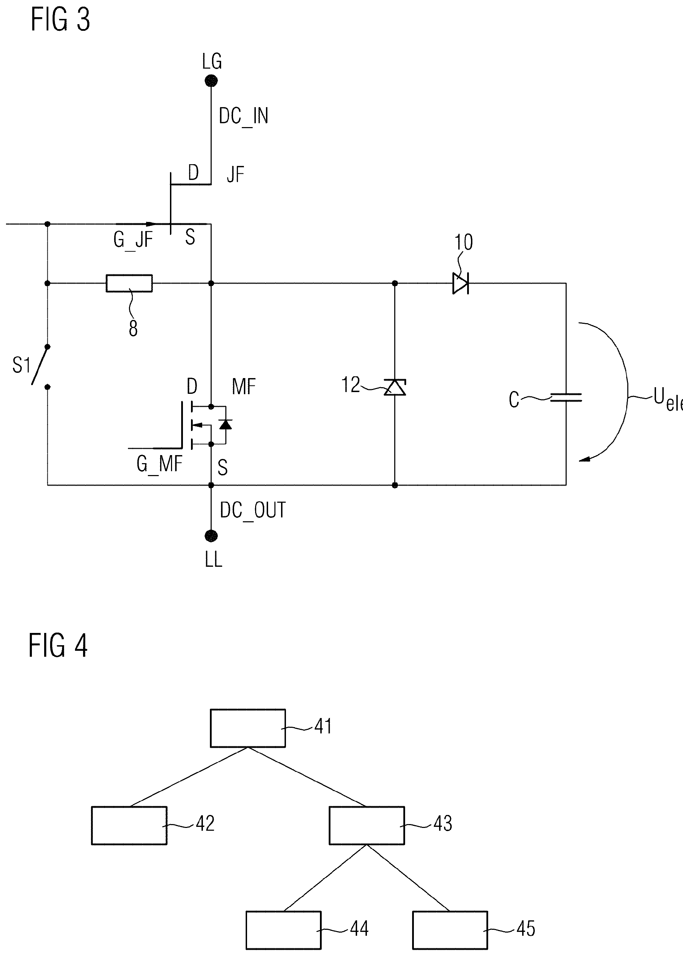

Fig. 3 ist eine vereinfachte Darstellung von Fig. 2. Anhand der Fig. 3 werden die verschiedenen Betriebsarten, die in Fig. 4 bis 9 beschrieben sind, erläutert. In Fig. 3 wird nur "die obere Hälfte" der Fig. 2 dargestellt; auf die Darstellung einiger dem Fachmann selbstverständlicher Bauelemente wie Dioden 11, 12 und impliziter Bauelemente wie einer Steuereinheit zur Ansteuerung der HL-Stellglieder JF, MF und eine Strommessvorrichtung zum Erkennen eines Fehlers (Überstrom, Kurzschluss) im Hauptstrompfad L wurde der Vereinfachung und Übersichtlichkeit halber verzichtet. Bezüglich der Beschreibung der Schaltung wird auf die Beschreibung von Fig. 2 verwiesen, die hier analog gilt. Die in gezeigte Fig. 3 Schaltung könnte in einer unidirektionalen DC-Anwendung zum Einsatz kommen. Dabei würde ein Eingangs-Gleichstrom DC_IN von dem netzseitigen Anschluss LG in Richtung zu dem selbstleitenden HL-Stellglied JF hin fließen und ein Ausgangs-Gleichstrom DC_OUT von dem selbstsperrenden HL-Stellglied MF in Richtung zu dem lastseitigen Anschluss LL fließen.

Fig. 4 zeigt eine Übersicht verschiedener Betriebsarten. Der Kasten 41 symbolisiert alle Verschaltungen von zwei JFETs und zwei MOSFETs in einem Hauptstrompfad. Der Kasten 42 symbolisiert als Teilmenge von 41 die Verschaltungen, bei denen gemäß Fig. 1 die selbstsperrenden Halbleiter-Stellglieder MF und die selbstleitenden Halbleiter-Stellglieder JF jeweils unmittelbar nebeneinander verschaltet sind. Der Kasten 43 symbolisiert als Teilmenge von 41 die Verschaltungen, bei denen gemäß Fig. 2 die selbstsperrenden Halbleiter-Stellglieder MF zwischen den selbstleitenden Halbleiter-Stellgliedern JF verschaltet sind.

Der Kasten 44 symbolisiert als Teilmenge von 43 eine Betriebsart A, bei der das Schutzschaltgerät 1 unmittelbar (von selbst) in einen leitenden Zustand übergeht: das Schutzschaltgerät 1 erreicht automatisch einen Zustand, in dem die selbstleitenden Halbleiter-Stellglieder JF einen Strom durch den Hauptstrompfad L zulassen.

Der Kasten 45 symbolisiert als Teilmenge von 43 eine Betriebsart B, bei der das Schutzschaltgerät 1 erst nach einer Freigabe (einen Steuerbefehl) in einen leitenden Zustand übergeht: das Schutzschaltgerät 1 erreicht automatisch einen sicheren Zustand, in dem die selbstleitenden Halbleiter-Stellglieder JF den Hauptstrompfad L sperren.

Fig. 5-6 zeigen die Vorgänge bei Vorliegen einer Ausbildung eines Netzes und nennenswerter Last (= Standardfall).

Fig. 5 zeigt den Vorgang bei Ausbildung des Netzes und nennenswerter Last in dem Betrieb A, der unmittelbar in einen leitenden Zustand übergeht. Mit "Ausbildung des Netzes" ist gemeint, dass Netzspannung bzw. Spannung an der Netzseite vorhanden ist.

Schritt 51: Zu Beginn ist der HV-Schalter JF leitend, der LV-Schalter MF sperrend und der Schalter S1 sperrend. Durch die Last am lastseitigen Anschluss LL fließt ein Hauptstrom durch das Schutzschaltgerät 1 (HV-Schalter JF ist leitend). Beim LV-Schalter MF fließt der Hauptstrom in den Kondensator C und baut eine Versorgungsspannung Uelec auf.

Schritt 52: Sobald die Versorgungsspannung U_elec im Kondensator C eine für die Spannungsversorgung ausreichende Höhe erreicht hat, z. B. 25 V, wird der LV-Schalter MF leitend geschaltet. Dadurch kann der Hauptstrom bei minimaler Impedanz durch das Schutzschaltgerät 1 fließen.

Schritt 53: Sinkt die Versorgungsspannung Uelec aufgrund von Entladung unter eine definierte Schwelle, wird der LV-Schalter MF für eine definierte Zeitspanne in den sperrenden Zustand gebracht; die Dauer der Zeitspanne (Ausschaltimpuls) kann in Abhängigkeit vom Hauptstrom gewählt werden. Dadurch kommt es zu einem Spannungsabfall über dem LV-Schalter MF und damit zu einer erneuten Aufladung des Kondensators C. Ist die Versorgungsspannung U_elec im Kondensator C wieder hoch genug für die Spannungsversorgung, wird der LV-Schalter MF wieder in den leitenden Zustand geschaltet.

Die Schritte 51-53 können als Befehle in einem Computerprogrammprodukt realisiert sein, die bewirken, dass das Schutzschaltgerät die Verfahrensschritte ausführt.

Fig. 6 zeigt den Vorgang bei Ausbildung des Netzes und nennenswerter Last in dem Betrieb B, der erst nach Freigabe in einen leitenden Zustand übergeht.

Schritt 61: Zu Beginn ist der HV-Schalter JF leitend, der LV-Schalter MF sperrend und der Schalter S1 leitend. Durch die Last am lastseitigen Anschluss LL fließt ein Hauptstrom durch das Schutzschaltgerät 1 (HV-Schalter JF ist leitend). Beim LV-Schalter MF fließt der Hauptstrom in den Kondensator C und baut eine Versorgungsspannung Uelec auf.

Schritt 62: Sobald die Versorgungsspannung U_elec im Kondensator C eine für die Spannungsversorgung ausreichende Höhe erreicht hat, z. B. 25 V, wird der HV-Schalter JF durch die an seinem Gate anliegende Versorgungsspannung von selbst sperrend geschaltet. Der LV-Schalter MF ist ebenfalls noch sperrend. Der Betrieb erreicht also automatisch einen sicheren Zustand

Schritt 63: Bei einer wie auch immer gearteten Freigabe, sei es intern, z. B. wenn das gesamte System einsatzbereit ist oder extern, z. B. durch eine Schaltanforderung, wird der Schalter S1 hochohmig geschaltet und der LV-Schalter MF leitend geschaltet. Durch das Schalten des Schalters S1 in einen hochohmigen Zustand wird der HV-Schalter JF selbstleitend. Der Hauptstrom kann nun bei minimaler Impedanz fließen.

Schritt 64: Sinkt die Versorgungsspannung Uelec unter eine definierte Schwelle (Entladung), wird der LV-Schalter MF für eine definierte Zeitspanne in den sperrenden Zustand gebracht; die Dauer der Zeitspanne (Ausschaltimpuls) kann in Abhängigkeit vom Hauptstrom gewählt werden. Dadurch kommt es zu einem Spannungsabfall über dem LV-Schalter MF und damit zu einer erneuten Aufladung des Kondensators C. Ist die Versorgungsspannung U_elec im Kondensator C hoch genug für die Spannungsversorgung, wird der LV-Schalter MF wieder in den leitenden Zustand geschaltet.

Die Schritte 61-64 können als Befehle in einem Computerprogrammprodukt realisiert sein, die bewirken, dass das Schutzschaltgerät die Verfahrensschritte ausführt.

Fig. 7 zeigt den Vorgang bei Ausbildung des Netzes und keiner Last, sowohl für Betrieb A als auch für Betrieb B.

Schritt 71: Zunächst ist der HV-Schalter JF leitend und der LV-Schalter MF sperrend. Da am lastseitigen Anschluss LL keine Last angeschlossen ist, befinden sich die Anschlüsse LG, LL auf demselben elektrischen Potential und es fließt kein Hauptstrom durch das Schutzschaltgerät 1. Somit bleibt auch der Spannungsabfall über dem LV-Schalter MF aus.

Schritt 72: Sobald am lastseitigen Anschluss LL eine Last vorliegt, laufen die Verfahrensschritte ab, wie oben in Fig. 5 und Fig. 6 beschrieben.

Die Schritte 71-72 können als Befehle in einem Computerprogrammprodukt realisiert sein, die bewirken, dass das Schutzschaltgerät die Verfahrensschritte ausführt.

Fig. 8-9 zeigt die Vorgänge bei Ausbildung des Netzes und einem Kurzschluss.

Fig. 8 zeigt den Vorgang bei Ausbildung des Netzes und Kurzschluss für den Betrieb A, der unmittelbar in einen leitenden Zustand übergeht.

Schritt 81: Zu Beginn ist der HV-Schalter JF leitend, der LV-Schalter MF sperrend und der Schalter S1 sperrend. Durch die Last am lastseitigen Anschluss LL fließt ein Hauptstrom durch das Schutzschaltgerät 1 (HV-Schalter JF ist leitend). Beim LV-Schalter MF fließt der Hauptstrom in den Kondensator C und baut eine Versorgungsspannung Uelec auf.

Schritt 82: Da der Hauptstrom aufgrund des Kurzschlusses binnen mehrerer 10 µs auf ein Mehrfaches des Nennstroms ansteigen kann und die Strommessung im Hauptstromkreis dieses Stromverhalten detektiert, wird, anstatt den LV-Schalter MF leitend zu schalten, der HV-Schalter JF in den sperrenden Zustand gebracht, sei es durch ein Schalten des Schalters S1 in einen niedrigohmigen Zustand (Kaskodenschaltung) oder durch ein Ansteuern des Gate des HV-Schalter JF mittels der Versorgungsspannung.

Schritt 83: Sinkt die Versorgungsspannung Uelec unter eine definierte Schwelle (Entladung), wird der HV-Schalter JF für eine definierte Zeitspanne in den leitenden Zustand gebracht; die Dauer der Zeitspanne (Ausschaltimpuls) kann in Abhängigkeit vom Hauptstrom gewählt werden. Dadurch kommt es zu einem Spannungsabfall über dem LV-Schalter MF und damit zu einer erneuten Aufladung des Kondensators C. Ist die Versorgungsspannung Uelec im Kondensator C hoch genug für die Spannungsversorgung, wird der HV-Schalter JF wieder in den sperrenden Zustand geschaltet.

Die Herausforderung bei dieser Betriebsart ist, dass insbesondere beim Aufschalten auf den Kurzschluss sichergestellt sein muss, dass die Reaktionskette (z. B. Spannung vorhanden, Strommessung aktiv, Abschaltbefehl ausgeben) schnell genug ist.

Die Schritte 81-83 können als Befehle in einem Computerprogrammprodukt realisiert sein, die bewirken, dass das Schutzschaltgerät die Verfahrensschritte ausführt.

Fig. 9 zeigt den Vorgang bei Ausbildung des Netzes und Kurzschluss für den Betrieb B, der erst nach Freigabe in einen leitenden Zustand übergeht.

Schritt 91: Zu Beginn ist der HV-Schalter JF leitend, der LV-Schalter MF sperrend und der Schalter S1 niederohmig (= leitend). Netzspannung baut sich auf und ein relativ hoher Hauptstrom, der aufgrund des Kurzschlusses ein Mehrfaches des Nennstroms betragen kann, fließt durch den Schalter (HV-Schalter JF ist leitend). Beim LV-Schalter MF fließt der Hauptstrom in den Kondensator C und baut die Versorgungsspannung Uelec auf.

Schritt 92: Da der Schalter S1 niederohmig gehalten wird, wird unmittelbar beim Aufbau der Versorgungsspannung Uelec der HV-Schalter JF in einen sperrenden Zustand gebracht, da er wie in einer Kaskodenschaltung verschaltet ist.

Die Schritte 91-92 können als Befehle in einem Computerprogrammprodukt realisiert sein, die bewirken, dass das Schutzschaltgerät die Verfahrensschritte ausführt.

Die Ausführung zeigt, dass man bei dem Betrieb B "Betrieb, der erst nach Freigabe in einen leitenden Zustand übergeht" keine Herausforderungen hinsichtlich des Timing bei der Kurzschluss-Abschaltung hat. Sobald eine Versorgungsspannung im Kondensator C vorhanden ist, geht der HV-Schalter JF aufgrund der Kaskodenschaltung in den Sperrbetrieb und stellt damit einen sicheren Zustand des Schutzschaltgeräts her. Daher ist unter dem Gesichtspunkt "Sicherheit" der Betrieb B zu bevorzugen.

### Bezugszeichenliste

- 1: SSCB
- 2: HV-Schalter
- 2.1: HV-Schalter
- 2.2: HV-Schalter
- 4: LV-Schalter
- 6: Strommessvorrichtung
- 8: Strommesswiderstand
- 9: Widerstand, elektrischer
- 10: Diode
- 11: Diode, Bodydiode, intrinsische Diode
- 12: Zener-Diode
- 13: Schottky-Diode
- 14: Datenübertragungspfad
- 16: Ansteuerpfad
- 18: Ansteuerpfad
- 20: Ansteuerpfad
- 22: Kontaktpunkt
- 22': Kontaktpunkt
- 24: Kontaktpunkt
- 24': Kontaktpunkt
- 26: Kontaktpunkt
- 26': Kontaktpunkt
- 27: Kontaktpunkt
- 27': Kontaktpunkt
- 28: Leitung, elektrische
- 28': Leitung, elektrische
- 31: digitale Recheneinheit, Mikrocontroller
- 32: Datenspeicher
- 41: Kasten
- 42: Kasten
- 43: Kasten
- 44: Kasten
- 51: Schritt
- 52: Schritt
- 53: Schritt
- 61: Schritt
- 62: Schritt
- 63: Schritt
- 64: Schritt
- 71: Schritt
- 72: Schritt
- 81: Schritt
- 82: Schritt
- 83: Schritt
- 91: Schritt
- 92: Schritt
- C: elektrischer Ladungsspeicher
- C.1: erster Anschluss von C
- C.2: zweiter Anschluss von C
- CU: Steuereinheit
- D: Drain-Anschluss
- G_JF: Steueranschluss von JF
- G_MF: Steueranschluss von MF
- JF: selbstleitendes Halbleiter-Stellglied
- L: Hauptstrompfad
- LG: netzseitiger Anschluss
- LL: lastseitiger Anschluss
- MF: selbstsperrendes Halbleiter-Stellglied
- P: Potential-Bezugspunkt
- S: Source-Anschluss
- U_{elec}: elektrische Spannung von C

## Patentansprüche

1. Halbleiterbasiertes Schutzschaltgerät (1), aufweisend
- netzseitige Anschlüsse (LG) und lastseitige Anschlüsse (LL),
- einen Hauptstrompfad (L) zum Leiten eines Hauptstroms zwischen den netzseitigen und den lastseitigen Anschlüssen (LG, LL),
- zwei antiseriell in den Hauptstrompfad (L) geschaltete selbstleitende Halbleiter-Stellglieder (JF), die jeweils einen Steueranschluss (G_JF) zur Spannungssteuerung der selbstleitenden Halbleiter-Stellglieder (JF) aufweisen,
- zwei antiseriell in den Hauptstrompfad (L) geschaltete selbstsperrende Halbleiter-Stellglieder (MF), die jeweils einen Steueranschluss (G_MF) zur Spannungssteuerung der selbstsperrenden Halbleiter-Stellglieder (MF) aufweisen,
- einen parallel zu den selbstsperrenden Halbleiter-Stellgliedern (MF) geschalteten Ladungsspeicher (C), der durch eine Sperrung des Hauptstroms durch die selbstsperrenden Halbleiter-Stellglieder (MF) geladen werden kann und im geladenen Zustand eine Versorgungsspannung (U_{elec}) zum Betreiben des Schutzschaltgeräts (1) bereitstellt.

2. Schutzschaltgerät nach Anspruch 1, aufweisend:
- eine Steuereinheit (CU) zur Spannungssteuerung der Halbleiter-Stellglieder (JF, MF), wobei der Ladungsspeicher (C) im geladenen Zustand eine Versorgungsspannung (U_{elec}) für die Steuereinheit (CU) und die Spannungssteuerung der Halbleiter-Stellglieder (JF, MF) bereitstellt.

3. Schutzschaltgerät nach einem der Ansprüche1 bis 2,
wobei die selbstsperrenden Halbleiter-Stellglieder (MF) zwischen den selbstleitenden Halbleiter-Stellgliedern (JF) verschaltet sind.

4. Schutzschaltgerät nach einem der Ansprüche 1 bis 3,
wobei die selbstsperrenden Halbleiter-Stellglieder (MF) und die selbstleitenden Halbleiter-Stellglieder (JF) jeweils paarweise antiseriell in Reihe verschaltet sind.

5. Schutzschaltgerät nach einem der vorhergehenden Ansprüche, aufweisend eine Strommessvorrichtung (6) im Hauptstrompfad (L).

6. Schutzschaltgerät nach einem der vorhergehenden Ansprüche, aufweisend mindestens ein Schaltelement (S1), durch das der Ladungsspeicher (C) mit den Steueranschlüssen (G_JF) der selbstleitenden Halbleiter-Stellglieder (JF) elektrisch verbunden oder davon getrennt werden kann.

7. Schutzschaltgerät nach Anspruch 6, wobei das besagte mindestens eine Schaltelement (S1) durch die Steuereinheit (CU) betätigbar ist.

8. Verfahren zum Betreiben eines halbleiterbasierten Schutzschaltgeräts (1), das zwei selbstleitende Halbleiter-Stellglieder (JF) aufweist, welche antiseriell in einen Hauptstrompfad (L) des Schutzschaltgeräts (1) geschaltet sind, wobei das Verfahren folgende Schritte aufweist:
- Leiten eines Hauptstroms durch den Hauptstrompfad (L), der netzseitige und lastseitige Anschlüsse (LG, LL) des Schutzschaltgeräts (1) elektrisch verbindet, wobei der Hauptstrom durch eine zwischen den netzseitigen Anschlüssen (LG) und lastseitigen Anschlüssen (LL) anliegende Spannung hervorgerufen wird;
- Aufladen eines Ladungsspeichers (C), welcher parallel zu zwei antiseriell in den Hauptstrompfad (L) geschalteten selbstsperrenden Halbleiter-Stellgliedern (MF) geschaltet ist, durch den hervorgerufenen Hauptstrom, indem ein Hauptstrom durch die selbstsperrenden Halbleiter-Stellglieder (MF) gesperrt wird;
- Erreichen eines geladenen Zustands des Ladungsspeichers (C), in welchem er eine Versorgungsspannung (U_{elec}) zum Betreiben des Schutzschaltgeräts (1) bereitstellt; und
- Betreiben des Schutzschaltgeräts (1) mittels der vom Ladungsspeicher (C) bereitgestellten Versorgungsspannung (U_{elec}).

9. Verfahren nach Anspruch 8, mit folgendem Schritt:
Betreiben einer Steuereinheit (CU), die zur Spannungssteuerung der Halbleiter-Stellglieder (JF, MF) ausgebildet ist, und/oder der zwei selbstleitenden Halbleiter-Stellglieder (JF) und/oder der zwei selbstsperrenden Halbleiter-Stellglieder (MF) mittels der vom Ladungsspeicher (C) bereitgestellten Versorgungsspannung (U_{elec}).

10. Verfahren nach einem der Ansprüche 8 oder 9, mit folgendem Schritt:
Falls die Versorgungsspannung (U_{elec}) unter einen definierten kritischen Schwellwert sinkt,
werden die selbstsperrenden Halbleiter-Stellglieder (MF) von einem leitenden Zustand in einen sperrenden Zustand gebracht, um den Ladungsspeicher (C) wieder über den Schwellwert aufzuladen.

11. Verfahren nach Anspruch 10, wobei die Länge eines Zeitraums, während dessen die selbstsperrenden Halbleiter-Stellglieder (MF) zum Aufladen des Ladungsspeichers (C) in einem sperrenden Zustand sind, in Abhängigkeit vom Hauptstrom und von den an den Ladungsspeicher (C) angeschlossenen Lasten gewählt wird.

12. Verfahren nach einem der Ansprüche 8 bis 11, wobei die selbstleitenden Halbleiter-Stellglieder (JF) mit den selbstsperrenden Halbleiter-Stellgliedern (MF) in einer Kaskodenschaltung so verschaltet sind, dass die selbstleitenden Halbleiter-Stellglieder (JF) in den sperrenden Zustand wechseln, sobald der Ladungsspeicher (C) eine Versorgungsspannung (U_{elec}) aufgebaut hat, die zur Ansteuerung der selbstleitenden Halbleiter-Stellglieder (JF) ausreicht.

13. Verfahren nach einem der Ansprüche 8 bis 11, wobei bei einer Detektion eines Kurzschlussstroms im Hauptstrompfad (L) der auf eine zur Ansteuerung der selbstleitenden Halbleiter-Stellglieder (JF) ausreichende Versorgungsspannung (U_{elec}) geladene Ladungsspeicher (C) mittels eines Schaltelements (S1) mit Steueranschlüssen (G_JF) der selbstleitenden Halbleiter-Stellglieder (JF) elektrisch verbunden wird, sodass die selbstleitenden Halbleiter-Stellglieder (JF) in den sperrenden Zustand wechseln.

14. Computerprogrammprodukt, umfassend Befehle, die bewirken, dass das Schutzschaltgerät (1) des Anspruchs 1 die Verfahrensschritte nach einem der Ansprüche 8 bis 13 ausführt.

15. Computerlesbares Medium, auf dem das Computerprogramm nach Anspruch 14 gespeichert ist.
